(19)

Europäisches Patentamt
European Patent Office
Office européen des brevets

(11) **EP 3 192 899 A1**

(12) **EUROPEAN PATENT APPLICATION**
published in accordance with Art. 153(4) EPC

(43) Date of publication:
19.07.2017 Bulletin 2017/29

(51) Int Cl.:
**C30B 29/36** *(2006.01)*    **C30B 19/04** *(2006.01)*

(21) Application number: 15840329.5

(86) International application number:
**PCT/JP2015/004411**

(22) Date of filing: 31.08.2015

(87) International publication number:
**WO 2016/038845 (17.03.2016 Gazette 2016/11)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(30) Priority: **11.09.2014  JP 2014185223**

(71) Applicant: **Nippon Steel & Sumitomo Metal Corporation**
**Tokyo 100-8071 (JP)**

(72) Inventors:
• **KUSUNOKI, Kazuhiko**
**Tokyo 100-8071 (JP)**
• **KAMEI, Kazuhito**
**Tokyo 100-8071 (JP)**
• **SEKI, Kazuaki**
**Tokyo 100-8071 (JP)**
• **KISHIDA, Yutaka**
**Tokyo 100-8071 (JP)**
• **MORIGUCHI, Koji**
**Tokyo 100-8071 (JP)**
• **KAIDO, Hiroshi**
**Tokyo 100-8071 (JP)**

(74) Representative: **J A Kemp**
**14 South Square**
**Gray's Inn**
**London WC1R 5JJ (GB)**

(54) **METHOD FOR MANUFACTURING P-TYPE SiC SINGLE CRYSTAL**

(57)    A production method according to an embodiment includes a formation step (S1), a first growth step (S2), a recovery step (S3), and a second growth step (S4). In the formation step (S1), a Si-C solution containing Si, Al and C is formed in a crucible. In the first growth step (S2), a seed shaft is moved down to bring a SiC seed crystal attached to the bottom edge of the seed shaft onto contact with the Si-C solution, and thereafter, an Al-doped p-type SiC single crystal is grown on the SiC seed crystal. After the first growth step (S2), the Al concentration in the Si-C solution is increased in the recovery step (S3). After the recovery step (S3), the Al-doped p-type SiC single crystal is further grown in the second growth step (S4).

FIG. 4

EP 3 192 899 A1

**Description**

TECHNICAL FIELD

The present invention relates to a method for producing a p-type SiC single crystal. In particular, it relates to a method for producing a p-type SiC single crystal containing Al as a dopant by a solution growth technique.

BACKGROUND ART

Silicon carbide (SiC) is a thermally and chemically stable compound semiconductor. SiC is excellent in bandgap, breakdown voltage, electron saturation speed and thermal conductivity as compared with silicon (Si). Therefore, SiC draws attention as a material for next-generation power devices.

Especially for power devices that are high-voltage bipolar devices, such as IGBTs (insulated gate bipolar transistors), it is preferred that p-type SiC single crystals with low resistivity are used. In producing a p-type SiC single crystal, generally, Al (aluminum) is added as a dopant.

It is preferred that a p-type SiC single crystal is produced such that the variation in concentration of Al, which is a dopant, in the p-type SiC bulk single crystal is small.

The solution growth technique is a way of producing a SiC single crystal. According to the solution growth technique, a seed crystal is caused to contact a Si-C solution. The portion of the Si-C solution surrounding the seed crystal is put onto a supercooled state, whereby a SiC single crystal grows on the seed crystal. Here, the Si-C solution means a solution in which C (carbon) is dissolved in a melt of Si or a Si alloy.

An Al-doped p-type SiC single crystal can be produced by the solution growth technique if the Si-C solution contains Al.

In the meantime, "Solution Growth of P-type 4H-SiC Bulk Crystals with Low Resistivity" by Takayuki Shirai, et al., Materials Science Forum 778-780 (2014), p75-78 (Non-Patent Literature 1) discloses that a growth of an Al-doped p-type SiC bulk single crystal at a rate of crystal growth of 1.0 mm/h by the solution growth technique results in small variation in Al concentration in the height direction of the bulk.

CITATION LIST

NON-PATENT LITERATURE

Non-Patent Literature 1: Solution Growth of P-type 4H-SiC Bulk Crystals with Low Resistivity" by Takayuki Shirai, et al., Materials Science Forum 778-780 (2014), p75-78

SUMMARY OF INVENTION

TECHNICAL PROBLEM

The present inventors produced an Al-doped p-type SiC bulk single crystal by the solution growth technique. As a result, however, they found great variation in Al concentration in the height direction of the bulk.

An object of the present invention is to provide a method for producing a p-type SiC single crystal which is capable of reducing the variation in Al concentration.

SOLUTION TO PROBLEM

A p-type SiC single crystal production method according to an embodiment is a method for producing a p-type SiC single crystal by a solution growth technique by use of a production apparatus comprising a crucible and a seed shaft. The seed shaft includes a bottom edge to which a SiC seed crystal is attachable, and is movable up and down. The p-type SiC single crystal production method comprises a formation step, a first growth step, a recovery step, and a second growth step. In the formation step, a Si-C solution containing Si, Al and C is formed in the crucible. In the first growth step, the seed shaft is moved down to bring the SiC seed crystal attached to the bottom edge of the seed shaft onto contact with the Si-C solution, and thereafter, an Al-doped p-type SiC single crystal is grown on the SiC seed crystal. After the first growth step, an Al concentration in the Si-C solution is increased in the recovery step. After the recovery step, the Al-doped p-type SiC single crystal is further grown in the second growth step.

ADVANTAGEOUS EFFECTS OF INVENTION

A method for producing a p-type SiC single crystal according to the present embodiment is capable of reducing the variation in Al concentration in the produced p-type SiC single crystal.

BRIEF DESCRIPTION OF DRAWINGS

[FIG.1] FIG. 1 is a schematic diagram showing measurement positions where the Al concentration in a p-type SiC single crystal, which was produced in the following examples as a comparative example, was measured.
[FIG. 2] FIG. 2 is a graph showing the relationship between the Al concentration (Al-doping amount, unit: atoms/cm$^3$) in a SiC single crystal produced by a solution growth technique and the crystal growth temperature T (K).
[FIG. 3] FIG. 3 is a schematic diagram of a production apparatus used for implementing a method for producing a p-type SiC single crystal according to the present embodiment.
[FIG. 4] FIG. 4 is a flowchart of the p-type SiC single crystal production method according to the present embodiment.
[FIG. 5] FIG. 5 is a schematic diagram showing measurement positions where the Al concentration in a p-type SiC single crystal, which was produced in the following examples as an inventive example, was measured.

DESCRIPTION OF EMBODIMENTS

A method for producing a p-type SiC single crystal according to the present embodiment is implemented by use of a production apparatus comprising a crucible and a seed shaft. The method uses the solution growth technique to produce a p-type SiC single crystal. The seed shaft has a bottom edge to which a SiC seed crystal is attachable, and the seed shaft is movable up and down. The p-type SiC single crystal production method includes a formation step, a first growth step, a recovery step, and a second growth step. In the formation step, a Si-C solution containing Si, Al and C is formed in a crucible. In the first growth step, the seed shaft is moved down to bring the SiC seed crystal attached to the bottom edge of the seed shaft onto contact with the Si-C solution, and an Al-doped p-type SiC single crystal is grown on the SiC seed crystal. After the first growth step, the Al concentration in the Si-C solution is increased in the recovery step. After the recovery step, the Al-doped p-type SiC single crystal is further grown in the second growth step.

The present inventors produced Al-doped p-type SiC bulk single crystals by the solution growth technique, and measured the Al concentration (the Al-doping amount) at various positions in the height direction of the bulk.

Specifically, a material containing, in at%, Si: 50%, Al: 30% and Cu: 20% was put in a graphite crucible. The material in the graphite crucible was heated, whereby a Si-C solution (hereinafter referred to as a Si$_{50}$Al$_{30}$Cu$_{20}$ solution) was produced. The Si$_{50}$Al$_{30}$Cu$_{20}$ solution contained C (carbon) dissolved out from the graphite crucible. A p-type SiC bulk single crystal was grown by a solution growth technique using the Si$_{50}$Al$_{30}$Cu$_{20}$ solution, at a crystal growth temperature of 1800 °C for 20 hours. The produced p-type SiC bulk single crystal had a height of 1.6 mm.

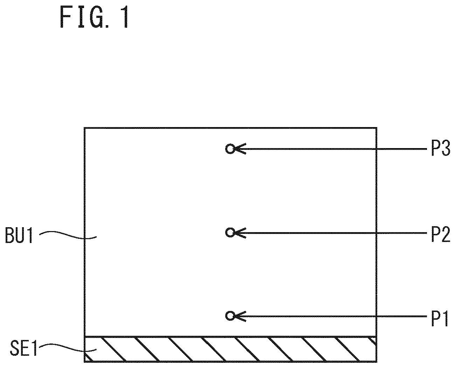

In the SiC bulk single crystal BU1 at a position P1 (at a position in an early phase of growth), at a position P2 (at a position in an intermediate phase of growth) and at a position P3 (at a position in a last phase of growth) indicated in FIG. 1, the Al concentrations (atoms/cm$^3$) were determined by SIMS (secondary ion mass spectrometry). The positions P1, P2 and P3 were at distances of 0.1 mm, 0.8 mm and 1.5 mm, respectively, from the end surface adjacent to the SiC seed crystal SE1 in the height direction. As a result, the Al concentration at the position P1 was $2.8 \times 10^{20}$ atoms/cm$^3$, that at the position P2 was $2.2 \times 10^{20}$ atoms/cm$^3$, and that at the position P3 was $1.4 \times 10^{20}$ atoms/cm$^3$. The Al concentration largely decreased as the growth progressed from the early phase to the last phase. In short, a long-time growth of a p-type SiC bulk single crystal resulted in great variation in Al concentration in the height direction of the bulk.

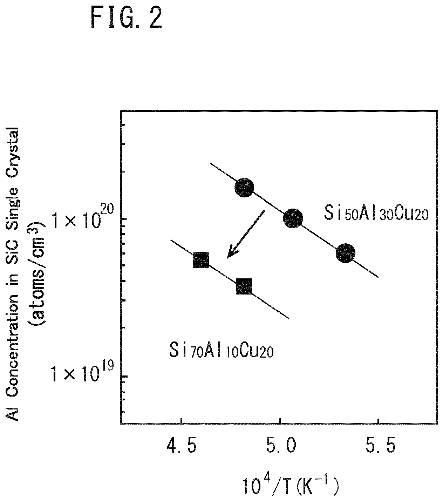

Then, the present inventors examined the relationship between the Al concentration in the Si-C solution and the Al concentration in the p-type SiC single crystal. FIG. 2 shows the relationship between the Al concentration (Al-doping amount, unit: atoms/cm$^3$) in a SiC single crystal produced by the solution growth technique and the crystal growth temperature T (K). FIG. 2 was obtained by the following method. The material in the graphite crucible was heated, whereby a Si$_{50}$Al$_{30}$Cu$_{20}$ solution was produced. P-type SiC single crystals were produced by the solution growth technique using the Si$_{50}$Al$_{30}$Cu$_{20}$ solution at various crystal growth temperatures. The p-type SiC single crystals had a height of 1.6 mm.

Further, the same examination was conducted with the composition of the Si-C solution changed. A material containing, in at%, Si: 70%, Al: 10% and Cu: 20% was put in the graphite crucible, and the material was heated, whereby a Si-C solution (hereinafter referred to as a Si$_{70}$Al$_{10}$Cu$_{20}$ solution) was produced. The Si$_{70}$Al$_{10}$Cu$_{20}$ solution contained C (carbon) dissolved out from the graphite crucible. P-type SiC single crystals having a height of 1.6 mm were produced by the solution growth technique using the Si$_{70}$Al$_{10}$Cu$_{20}$ solution at various crystal growth temperatures.

The Al concentrations (atoms/cm$^3$) in the produced SiC single crystals were determined by SIMS, and FIG. 2 was obtained. The measurement positions of the SiC single crystals corresponded to the position P1 (position in an early phase of growth) of the SiC single crystal BU1 illustrated in FIG. 1, which is at a distance of 0.1 mm from the end surface adjacent to the SiC seed crystal SE1 in the height direction.

As seen in FIG. 2, when p-type SiC single crystals produced at the same crystal growth temperature T are compared with each other, the Al concentration in the p-type SiC single crystal produced by using the $Si_{50}Al_{30}Cu_{20}$ solution was higher than the Al concentration in the p-type SiC single crystal produced by using the $Si_{70}Al_{10}Cu_{20}$ solution.

The following can be derived from these results. During a long-time growth of an Al-doped p-type SiC bulk single crystal by using a Si-Cu solution containing Al, the Al concentration in the Si-C solution decreases as time passes. Accordingly, the p-type SiC single crystal has great variation in Al concentration in the height direction.

Meanwhile, the higher the Al concentration in a p-type SiC single crystal, the lower the specific resistance of the p-type SiC single crystal. However, if the Al concentration in a p-type SiC single crystal is too high, the crystallinity of the p-type SiC single crystal becomes lower. Therefore, the lower limit of the Al concentration in a p-type SiC single crystal is preferably $3 \times 10^{19}$ atoms/cm$^3$, and more preferably $1 \times 10^{20}$ atoms/cm$^3$. The upper limit of the Al concentration in a p-type SiC single crystal is preferably $1 \times 10^{21}$ atoms/cm$^3$, and more preferably $5 \times 10^{20}$ atoms/cm$^3$.

In the above-described p-type SiC single crystal production method established based on these findings, after growing a p-type SiC single crystal in the first growth step, the Al concentration in the Si-C solution is increased in the recovery step. Then, after the recovery step, the growth of the p-type SiC single crystal is caused to proceed. This method prevents the produced p-type SiC single crystal from having great variation in Al concentration in the height direction.

In the above production method, the recovery step preferably includes a recovery step, a separation step, a concentration adjustment step, and a contact step. In the separation step, the seed shaft is moved up to separate the p-type SiC single crystal grown on the SiC seed crystal from the Si-C solution. After the separation step, the Al concentration in the Si-C solution is increased in the concentration adjustment step. After the concentration adjustment step, the seed shaft is moved down again to bring the p-type SiC single crystal onto contact with the Si-C solution in the contact step.

In this case, it is possible to adjust the Al concentration in the Si-C solution after separating the SiC single crystal grown on the SiC seed crystal from the liquid surface of the Si-C solution. Therefore, the concentration adjustment work is carried out easily.

In the recovery step, more preferably, the temperature of the Si-C solution is adjusted to the crystal growth temperature after the concentration adjustment step and before the contact step.

In this case, even if the temperature of the Si-C solution drops during the concentration adjustment step, the temperature of the Si-C solution can be raised to the crystal growth temperature before the second growth step.

In the concentration adjustment step, preferably, an Al-Si-based alloy is supplied to the Si-C solution.

In this case, it is easy to increase the Al concentration in the Si-C solution. The Al-Si-based alloy is, for example, an Al-Si alloy, an Al-Si-Cu alloy or the like. A phase diagram of an Al-Si alloy shows that 577 °C is a eutectic point (Al content: 12.6 mass%). Therefore, in order to raise the liquidus temperature, it is preferred that a hyper-eutectic Al-Si alloy having a high Si concentration is used.

Preferably, a Si-C solution further containing Cu is formed in the formation step, and the Al concentration and the Cu concentration in the Si-C solution are increased in the recovery step.

When the Si-C solution contains Al and the crucible contains graphite, Al and C may react to each other excessively, thereby causing a partial damage to the crucible. When the Si-C solution contains Cu, it inhibits reaction between Al and C. However, as with Al, during a growth of a single crystal, the Cu concentration in the Si-C solution is likely to decrease as time passes. In the above-described embodiment, in the recovery step, not only the Al concentration but also the Cu concentration in the Si-C solution is increased. This leads to inhibition of excess reaction between Al and C in the second growth step and following steps.

The details of the p-type SiC single crystal production method according to the present embodiment will hereinafter be described.

[Overall Structure of P-type SiC Single Crystal Production Apparatus]

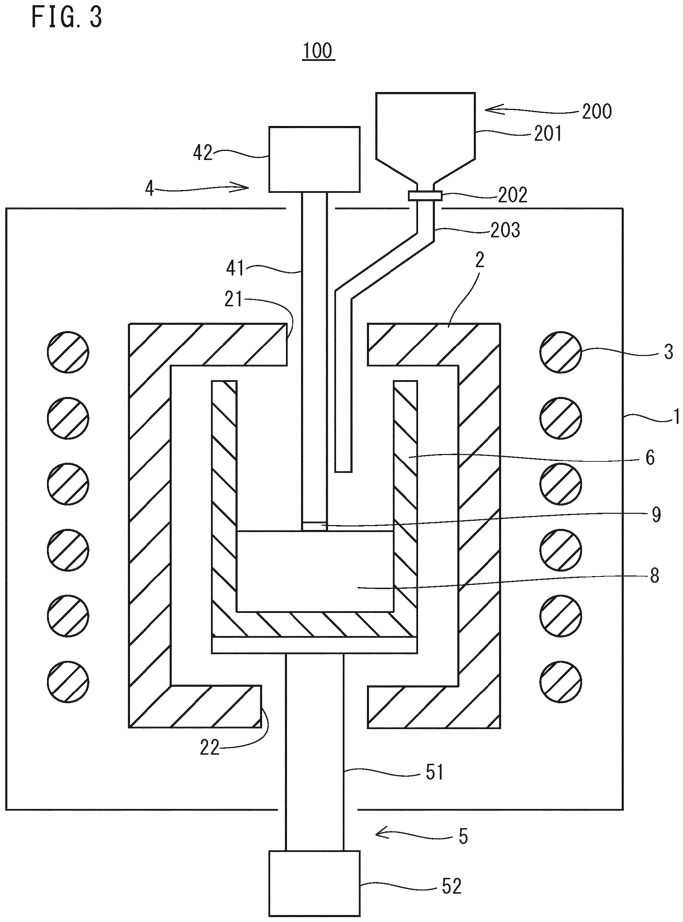

FIG. 3 is a schematic diagram of a production apparatus 100 for producing an Al doped p-type SiC single crystal according to the present embodiment. As illustrated in FIG. 3, the production apparatus 100 comprises a chamber 1, a heat insulator 2, a high-frequency heating coil 3, a lifting and lowering device 4 and a rotating device 5.

The chamber 1 is a case housing the heat insulator 2, the high-frequency heating coil 3 and a crucible 6. At the time of production of a p-type SiC single crystal, the chamber 1 is cooled with water.

The rotating device 5 includes a rotary member 51 and a drive unit 52. The rotary member 51 is shaped like a rod, and has a rotating table at the top edge. On the rotating table, the crucible 6 is placed. The bottom edge of the rotary member 51 is connected to the drive unit 52. At the time of production of a p-type SiC single crystal, the rotating device 5 rotates the crucible 6. Specifically, the drive unit 52 rotates the rotary device 51, thereby causing the crucible 6 to rotate about the axis of the rotary member 51.

The crucible 6 is a box with an open top. The crucible 6 contains a Si-C solution 8. The Si-C solution 8 contains silicon (Si), aluminum (Al) and carbon (C) that are elements of an Al-doped p-type SiC single crystal. As will be described later, in addition to Si, Al and C, the Si-C solution 8 may contain one or more other elements.

The Si-C solution 8 is produced by melting the material for the Si-C solution by heat. The material may contain only Si and Al, or alternatively may contain not only Si and Al but also other metal elements. The metal elements that may be contained in the material for the Si-C solution are, for example, titanium (Ti), manganese (Mn), chromium (Cr), cobalt (Co), vanadium (V), iron (Fe), etc.

In a case where the Si-C solution contains Al as in the present embodiment, the Si-C solution preferably contains copper (Cu). Cu inhibits excess reaction between Al and C.

The material of the crucible 6 is graphite, for example. When the crucible 6 is made of graphite, the crucible 6 itself is a supply source of carbon for the Si-C solution 8. The crucible 6 may be made of a material other than graphite. For example, the crucible 6 may be made of ceramics or high melting point metal. When the crucible 6 cannot be used as a supply source of carbon, the material for the Si-C solution 8 contains C. Also, when the crucible 6 is made of a material other than graphite, the inner surface of the crucible 6 may be coated with graphite. The crucible 6 may have a lid although it is not illustrated in the drawings.

The lifting and lowering device 4 includes a seed shaft 41 and a drive unit 42. The drive unit 42 is disposed above the chamber 1. The seed shaft 41 is arranged concentrically with the rotary member 51. The bottom edge of the seed shaft 41 is located in the chamber 1, and the top edge of the seed shaft 41 is located above the chamber 1. Thus, the seed shaft 41 pierces onto the chamber 1 in the height direction.

The top edge of the seed shaft 41 is connected to the drive unit 42. The drive unit 42 moves up and down the seed shaft 41. The drive unit 42 also rotates the seed shaft 41 about the central axis of the seed shaft 41. The bottom edge of the seed shaft 41 is located in the crucible 6. A SiC seed crystal 9 is attachable to the bottom edge of the seed shaft 41.

The SiC seed crystal 9 is shaped like a plate, and is a SiC single crystal. During production by the solution growth technique, on the surface (crystal growth surface) of the SiC seed crystal 9, an Al-doped p-type SiC single crystal is produced and grown. When a p-type SiC single crystal of the 4H polytype is to be produced, the SiC seed crystal 9 is preferably a single crystal of the 4H polytype. More preferably, the surface (crystal growth surface) of the SiC seed crystal 9 is the (0001) plane or a plane that is 8° or less off-axis from the (0001) plane. In such a case, a p-type SiC single crystal is grown stably.

In producing a p-type SiC single crystal, the seed shaft 41 is moved down to bring the SiC seed crystal 9 onto contact with the SiC solution 8 as illustrated in FIG. 3. During this contact, the temperature of the Si-C solution 8 is maintained at the crystal growth temperature. The crystal growth temperature is the temperature of the Si-C solution 8 at which a p-type SiC single crystal is grown, and the crystal growth temperature depends on the composition of the Si-C solution 8. The crystal growth temperature is typically 1600 to 2000 °C.

The high-frequency heating coil 3 is arranged around the crucible 6. The high-frequency heating coil 3 is arranged coaxially with the seed shaft 41 and the rotary member 51. The high-frequency heating coil 3 heats the crucible 6 inductively and melts the material in the crucible 6, whereby the Si-C solution 8 is produced. The high-frequency heating coil 3 maintains the Si-C solution 8 at the crystal growth temperature.

The heat insulator 2 is shaped like a box, and has side walls, a top lid and a bottom lid. The side walls of the heat insulator 2 are disposed between the high-frequency heating coil 3 and the crucible 6. The side walls of the heat insulator 2 are arranged around the crucible 6. The top lid of the heat insulator 2 is disposed above the crucible 6. The top lid has a through hole 21 that the seed shaft 41 can pass through. The bottom lid of the heat insulator 2 is disposed below the crucible 6. The bottom lid has a through hole 22 that the rotary member 51 can pass through. In short, the heat insulator 22 surrounds the crucible 6 entirely. The heat insulator 2 includes a conventional heat insulating material. The heat insulating material is a shaped heat insulating member of a fiber or non-fiber material.

[Concentration Recovery Device]

The production apparatus 100 further comprises a concentration recovery device 200. The concentration recovery device 200 comprises a material hopper 201, an on-off valve 202 and a plumbing 203. The concentration recovery device 200 supplies Al to the Si-C solution 8 in the middle of a crystal growth to recover the Al concentration in the Si-C solution 8 that has decreased in the process of growing a p-type SiC single crystal.

The material hopper 201 is disposed above the chamber 1. The material hopper 201 contains an element (Al in this embodiment) of which concentration in the Si-C solution 8 is to be recovered. In this example, the material hopper 201 contains particles of an Al-Si-based alloy.

The plumbing 203 is connected to the bottom edge of the material hopper 201 via the on-off valve 202. The plumbing 203 extends downward through the through hole 21. The bottom edge of the plumbing 203 is located above the liquid surface of the Si-C solution 8 in the crucible 6. It is preferred that the bottom edge of the plumbing 203 is disposed below the top edge of the crucible 6 and above the liquid surface of the Si-C solution 8.

When the on-off valve 202 is opened, the Al (Al-Si-based alloy) contained in the material hopper 201 is supplied to the Si-C solution 8 via the plumbing 203. By regulating the on-off valve 202 appropriately, the amount of supply of the Al-Si-based alloy can be adjusted, whereby the Al concentration in the Si-C solution 8 can be adjusted.

[Method for Producing P-type SiC Single Crystal]

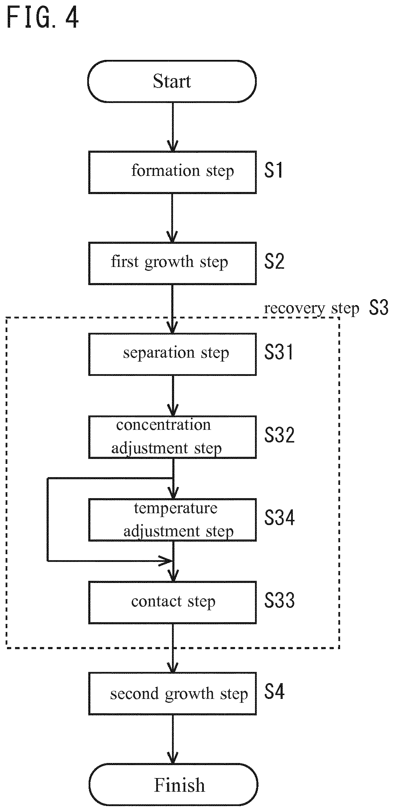

FIG. 4 is a flowchart showing a method for producing a p-type SiC single crystal by use of the above-described production apparatus 100. With reference to FIG. 4, the production method comprises a formation step (S1), a first growth step (S2), a recovery step (S3), and a second growth step (S4). In the formation step (S1), a Si-C solution 8 is formed. In the first growth step (S2), a p-type SiC single crystal is grown. In the recovery step (S3), the Al concentration in the Si-C solution 8 is increased. In the second growth step, the p-type SiC single crystal is grown further. In the production method according to the present embodiment, in the recovery step (S3), the Al concentration in the Si-C solution 8, which has decreased, is increased in the middle of the growth of the p-type SiC single crystal, whereby the Al concentration is returned almost to the initial state. This reduces the variation in Al concentration (Al-doping amount) of the produced p-type SiC bulk single crystal in the height direction. The steps will hereinafter be described in detail.

[Formation Step (S1)]

First, a SiC seed crystal 9 is attached to the bottom edge of the seed shaft 41. Next, the crucible 6 is placed on the rotary member 51 in the chamber 1. The crucible 6 preliminary contains a material for the Si-C solution 8. The material contains at least Si and Al. When the material of the crucible 6 does not contain C, the material for the Si-C solution 8 further contains C. As described above, it is preferred that the material for the Si-C solution 8 furthermore contains Cu.

After the crucible 6 is placed in the chamber 1, the Si-C solution 8 is formed. The chamber 1 is filled with an inert gas. After the filling with the inert gas, the material in the crucible 6 is heated to above the melting point by the high-frequency heating coil 3, whereby the Si-C solution 8 is formed. In a case where the material of the crucible 6 contains C, for example, in a case where the crucible 6 is made of graphite, heating of the crucible 6 causes dissolving of C out from the crucible 6 onto the melt of the material, and the Si-C solution 8 is formed. The formed Si-C solution 8 contains Si, Al and C. The Si-C solution 8 may further contain other elements (Cu, etc.). In a case where the crucible 6 is made of graphite, when C is dissolved out from the crucible 6 onto the Si-C solution 8, the C concentration in the Si-C solution 8 comes close to the saturation concentration.

In the p-type SiC single crystal production method according to the present embodiment, the Si-C solution 8 preferably satisfies the following formula (1).

$$0.14 \leq [Al]/[Si] \leq 2 \qquad (1)$$

wherein [Al] and [Si] are the Al content (mol%) and the Si content (mol%), respectively, in the Si-C solution 8.

The following definition is given.

$$F1 = [Al]/[Si]$$

When F1 is equal to or more than 0.14, the Al-doping amount of the SiC single crystal is equal to or more than $3 \times 10^{19}$ atoms/cm$^3$. In this case, the specific resistance of the SiC single crystal is sufficiently low. The lower limit of F1 is preferably 0.2, and more preferably 0.3.

On the other hand, if F1 is greater than 2, it may be impossible to crystallize SiC from the Si-C solution 8. As long as F1 is equal to or less than 2, SiC can be crystallized stably. The upper limit of F1 is preferably 1.5, and more preferably 1.

[First Growth Step (S2)]

In the first growth step, first, the SiC seed crystal 9 is brought onto contact with the Si-C solution 8. Specifically, the seed shaft 41 is moved down by the drive unit 42 to bring the SiC seed crystal 9 onto contact with the Si-C solution 8.

After the SiC seed crystal 9 comes onto contact with the Si-C solution 8, the temperature of the Si-C solution 8 is adjusted to the crystal growth temperature by the high-frequency heating coil 3. The portion of the Si-C solution 8 surrounding the SiC seed crystal 9 (which will be referred to simply as surrounding portion) is supercooled, whereby SiC in the surrounding portion is supersaturated. For example, by controlling the high-frequency heating coil 3, the temperature of the surrounding portion is caused to be lower than the temperature of the other portion of the SiC solution 8. Alternatively, the surrounding portion may be cooled by a refrigerant. Specifically, a refrigerant is circulated inside the seed shaft 41 to cool the SiC seed crystal 9 and the surrounding portion.

While SiC in the surrounding portion is kept supersaturated, the SiC seed crystal 9 and the crucible 6 (Si-C solution 8) are rotated. Rotating the seed shaft 41 about its axis causes the SiC seed crystal 9 to rotate. Rotating the rotary member 51 about its axis causes the crucible 6 to rotate. The direction of rotation of the SiC seed crystal 9 may be opposite to or the same as the direction of rotation of the crucible 6. The rotational speed may be constant or variable.

The seed shaft 41 moves up gradually while rotating. At that moment, an Al-doped p-type SiC single crystal is formed and grown on the surface (crystal growth surface) of the SiC seed crystal 9 in contact with the SiC solution 8.

[Recovery Step (S3)]

As the growth time in the first growth step becomes longer, the Al concentration in the Si-C solution 8 decreases. Then, the Al concentration in the growing p-type SiC single crystal decreases.

Therefore, the Al concentration in the Si-C solution 8 is increased in this recovery step. Specifically, the Al concentration in the Si-C solution 8 is increased to a value greater than the Al concentration at the end of the first growth step (S2) and not greater than the Al concentration at the start of the first growth step (S2). The way of increasing the Al concentration is supplying Al to the Si-C solution 8 by use of the concentration recovery device 200. The recovery step (S3) preferably includes a separation step (S31), a concentration adjustment step (S32) and a contact step (S33).

[Separation Step (S31)]

In the separation step (S31), the seed shaft 41 is moved up to separate the p-type SiC single crystal grown on the SiC seed crystal 9 from the liquid surface of the Si-C solution 8. In the concentration adjustment step, which will be described later, when Al is supplied from the concentration recovery device 200, a drop of Al from the plumbing 203 onto the liquid surface of the Si-C solution 8 causes a ripple on the liquid surface. If the SiC seed crystal 9 is kept in contact with the Si-C solution 8 in this moment, the growth of the p-type SiC single crystal will be unstable. Further, addition of Al causes a change in temperature of the Si-C solution 8, which may lead to instability in the growth of the p-type SiC single crystal. For these reasons, the p-type SiC single crystal grown on the SiC seed crystal 9 is separated from the Si-C solution 8.

[Concentration Adjustment Step (S32)]

After the separation step (S31), the concentration adjustment step (S32) is carried out. In the concentration adjustment step (S32), the Al concentration in the Si-C solution 8, which has decreased in the first growth step (S2), is increased. Specifically, the Al concentration in the Si-C solution is increased to a value greater than the Al concentration at the end of the first growth step (S2) and not greater than the Al concentration at the start of the first growth step (S2). More specifically, Al (Al-Si-based alloy in this example) is supplied from the concentration recovery device 200 to the Si-C solution 8. The amount of Al-Si-based alloy to be supplied is determined, for example, on the basis of the chemical composition of the Si-C solution 8 before the first growth step (S2) (that is, the chemical composition of the Si-C solution 8 based on the material) and the amount of Al lost by vaporization in the first growth step (S2). As described above, it is possible to adjust the amount of Al supply by regulating the on-off valve 202.

The Al concentration in the Si-C solution 8 is increased by the Al supply from the concentration adjustment device 200 to the Si-C solution 8. Then, the Al concentration in the Si-C solution 8 is recovered to a value greater than the Al concentration at the end of the first growth step (S2) and not greater than the Al concentration at the start of the first growth step (S2).

[Contact Step (S33)]

After the Al concentration in the Si-C solution 8 is recovered in the concentration recovery step (S32), the seed shaft 41 is moved down again to bring the bottom surface (crystal growth surface) of the p-type SiC single crystal grown on the SiC seed crystal 9 onto contact with the Si-C solution (S33). Then, the apparatus 100 gets prepared for the second growth step (S4).

[Second Growth Step (S4)]

After the recovery step (S3), the growth of the Al-doped p-type SiC single crystal is resumed to grow the p-type SiC single crystal further (S4). Through the recovery step (S3), the Al concentration in the Si-C solution 8 is recovered to a value greater than the Al concentration at the end of the first growth step (S2) and not greater than the Al concentration at the start of the first growth step (S2). This reduces the variation in Al concentration of the produced p-type SiC bulk single crystal in the height direction.

The recovery step (S3) and the second growth step (S4) may be repeated twice or more. Specifically, the recovery step (S3) may be carried out again after the second growth step (S4), and thereafter, the second growth step (S4) may be carried out.

[Temperature Adjustment Step (S34)]

In the recovery step (S3), it is preferred that a temperature adjustment step (S34) is carried out between the concentration adjustment step (S32) and the contact step (S33).

The Al supply to the Si-C solution 8 in the concentration adjustment step (S32) may cause a drop in the temperature of the Si-C solution 8 to below the preferred crystal growth temperature. In this case, before the contact step (S33), the Si-C solution 8 after supplied with Al is heated by the high-frequency heating coil 3 to the preferred crystal growth temperature. Thereby, the p-type SiC single crystal in the middle of a growth comes onto contact with the Si-C solution 8 having the preferred crystal growth temperature. Therefore, the growth of the p-type SiC single crystal proceeds again easily.

[Second Embodiment]

In the above-described embodiment, the recovery step (S3) is carried out by use of the concentration recovery device 200. However, there are other ways of carrying out the recovery step (S3) to increase the Al concentration in the Si-C solution 8.

For example, in the concentration adjustment step (S32) shown in FIG. 4, the crucible 6 is replaced with another crucible 6 containing a new material for the Si-C solution 8. Specifically, a material having the same composition as the material prepared in the formation step (S1) is put in a crucible 6 separate from the crucible 6 in the chamber 1. After the separation step (S31), the heating by the high-frequency heating coil 3 is stopped, and the inside of the chamber 1 is cooled to room temperature. Thereafter, the chamber 1 is opened, and the crucible 6 in the chamber 1 is replaced with the new crucible 6. After the new crucible 6 is placed in the chamber 1, the chamber 1 is filled with an inert gas. After the chamber 1 is filled with the inert gas, the material in the crucible 6 is heated by the high-frequency heating coil 3 to above the melting point, whereby the Si-C solution 8 is formed. The temperature of the Si-C solution 8 is raised to the crystal growth temperature, and thereafter, the contact step (S33) is carried out to bring the crystal growth surface of the p-type SiC single crystal onto contact with the Si-C solution 8. Then, the second growth step (S4) is carried out.

Even in this way, it is possible to increase the Al concentration in the Si-C solution 8 in the recovery step (S3), and the Al concentration can be recovered to a value greater than the Al concentration at the end of the first growth step (S2) and not greater than the Al concentration at the start of the first growth step (S2). Consequently, it is possible to reduce the variation in Al concentration of the produced p-type SiC bulk single crystal in the height direction.

[Third Embodiment]

As mentioned above, the Si-C solution 8 may contain Cu. In this case, in the Si-C solution 8, Cu inhibits excess reaction between Al and C. However, not only the Al concentration but also the Cu concentration in the Si-C solution 8 may decrease as the p-type SiC single crystal is growing. Therefore, it is preferred that the Cu concentration also is recoverable.

In the production method according to the present embodiment, not only the Al concentration but also the Cu concentration in the Si-C solution 8 is increased in the recovery step (S3). For example, in the concentration adjustment step (S32), a Cu alloy as well as the Al-Si-based alloy is supplied from the recovery device 200 to the Si-C solution 8. Thereby, not only the Al concentration but also the Cu concentration can be increased in the recovery step (S3). Specifically, as with the Al concentration, the Cu concentration is increased to a value greater than the Cu concentration at the end of the first growth step (S2) and not greater than the Cu concentration at the start of the first growth step (S2). This allows for inhibition of excess reaction between Al and C in the second growth step (S4). The Cu alloy to be supplied is, for example, a Si-Al-Cu alloy that is based on a hypereutectic Al-Si composition with a part of Si replaced with Cu. Alternatively, copper metal may be supplied directly.

When the Si-C solution 8 contains Cu, the Si-C solution 8 preferably satisfies the following formula (2).

$$0.03 < [Cu]/([Si]+[Al]+[Cu]) \le 0.5 \qquad (2)$$

where [Cu], [Si] and [Al] are the concentrations (mol%) of the respective elements in the Si-C solution 8.

The following definition is given.

$$F2 = [Cu]/([Si]+[Al]+[Cu])$$

If F2 is equal to or less than 0.03, it is not possible to satisfactorily achieve the effect of inhibiting reaction between Al in the Si-C solution 8 and graphite. In this case, therefore, the graphite crucible reacts strongly with Al during the growth of the crystal, which may lead to breakage of the graphite crucible. If F2 is more than 0.03, it means that the Cu concentration in the Si-C solution 8 is sufficiently high. In this case, therefore, the graphite crucible is unlikely to be broken during the growth of the SiC single crystal, and it is possible to grow the Al-doped SiC single crystal. The lower limit of F2 is preferably 0.05, and more preferably 0.1.

On the other hand, if F2 is more than 0.5, the amount of carbon dissolved in the Si-C solution 8 is inadequate. Accordingly, the rate of growth of the SiC single crystal decreases significantly. Moreover, Cu is an element with high vapor pressure. Therefore, when F2 becomes more than 0.5, vaporization of Cu from the Si-C solution 8 becomes prominent, and the liquid surface of the Si-C solution 8 becomes lower significantly. The lowering of the liquid surface of the Si-C solution 8 is accompanied with a drop in the temperature of the crystal growth interface, which heightens the degree of supersaturation of the Si-C solution 8. Accordingly, it is difficult to maintain stable crystal growth. When F2 is equal to or less than 0.5, the decrease in the rate of growth of the SiC single crystal can be inhibited, and it is possible to maintain stable crystal growth. The upper limit of F2 is preferably 0.4, and more preferably 0.3.

As a result of SIMS, it was found that Cu contained in the Si-C solution was hardly taken onto the SiC single crystal. Accordingly, the Cu concentration has substantially no effect on the properties of the SiC single crystal.

In the present embodiment, the Si-C solution 8 may optionally contain one or more elements selected from the group consisting of Ti (titanium), Mn (manganese), Cr (chromium), Co (cobalt), Ni (nickel), V (vanadium), Fe (iron), Dy (dysprosium), Nd (neodymium), Tb (terbium), Ce (cerium), Pr (praseodymium) and Sc (scandium). Any of the elements Ti, Mn, Cr, Co, Ni, V, Fe, Dy, Nd, Tb, Ce, Pr and Sc increases the amount of carbon dissolved in the Si-C solution 8. By using a Si-C solution 8 with more carbon dissolved therein, it is possible to increase the rate of growth of the SiC single crystal.

When the Si-C solution 8 contains such one or more optional elements in addition to Cu, the Si-C solution 8 preferably satisfies not the formula (2) but the following formula (3).

$$0.03 < [Cu]/([Si]+[Al]+[Cu]+[M]) < 0.5 \qquad (3)$$

where the content (mol%) of the one or more elements selected from the group consisting of Ti, Mn, Cr, Co, Ni, V, Fe, Dy, Nd, Tb, Ce, Pr and Sc is substituted for [M]. When the Si-C solution 8 contains such two or more elements as optional elements, the total content (mol%) of the optional elements is substituted for [M].

The following definition is given.

$$F3 = [Cu]/([Si]+[Al]+[Cu]+[M])$$

If F3 is more than 0.03, it means that the Cu concentration in the Si-C solution 8 is sufficiently high. In this case, therefore, the graphite crucible is unlikely to be broken during the growth of the SiC single crystal. The lower limit of F3 is preferably 0.05, and more preferably 0.1.

On the other hand, if F3 is less than 0.5, the decrease in the rate of growth of the SiC single crystal is inhibited, and the vaporization of Cu is inhibited. The upper limit of F3 is preferably 0.4, and more preferably 0.3.

[Examples]

[Comparative Example]

A material containing, in at%, Si: 50%, Al: 30% and Cu: 20% was put in a graphite crucible. The graphite crucible was placed in the chamber of the SiC single crystal production apparatus, and the material in the graphite crucible was heated, whereby a $Si_{50}Al_{30}Cu_{20}$ solution was produced. By the solution growth technique using the $Si_{50}Al_{30}Cu_{20}$ solution, a SiC bulk single crystal was grown at the crystal growth temperature of 1800 °C for 20 hours. The produced SiC bulk single crystal had a height of 1.6 mm.

[Inventive Example]

Following the flowchart shown in FIG. 4, a p-type SiC single crystal was produced by a solution growth technique. Specifically, a graphite crucible containing a material was placed in the chamber of the SiC single crystal production apparatus used for the production of the comparative example, and the material in the graphite crucible was heated, whereby a $Si_{50}Al_{30}Cu_{20}$ solution was produced (formation step S1).

By the solution growth technique using the $Si_{50}Al_{30}Cu_{20}$ solution, a p-type SiC bulk single crystal was grown at the crystal growth temperature of 1800 °C for 10 hours (first growth step S2).

After the first growth step (S2), the seed shaft was moved up to separate the p-type SiC single crystal grown on the SiC seed crystal from the Si-C solution (separation step S31). Thereafter, the concentration adjustment step (S32) according to the above-described second embodiment was carried out. Specifically, the heating by the high-frequency heating coil was stopped, and the inside of the chamber was cooled to room temperature. Then, the chamber was opened, and the crucible in the chamber was replaced with a new crucible containing a material for a $Si_{50}Al_{30}Cu_{20}$ solution. After the new crucible was placed in the chamber, the chamber was filled with an inert gas. After the filling with the inert gas, the material in the crucible was heated to above the melting point by the high-frequency heating coil, whereby a $Si_{50}Al_{30}Cu_{20}$ solution was produced. The temperature of the $Si_{50}Al_{30}Cu_{20}$ solution was adjusted to 1800 °C (crystal growth temperature), and thereafter, the seed shaft was moved down to bring the bottom surface (crystal growth surface) of the growing p-type SiC single crystal onto contact with the newly produced $Si_{50}Al_{30}Cu_{20}$ solution (contact step S33). After the contact, the p-type SiC bulk single crystal was further grown at the crystal growth temperature of 1800 °C for 10 hours (second growth step S4). The produced p-type SiC bulk single crystal had a height (total of the height grown in the first growth step and the height grown in the second growth step) of 1.6 mm.

[Measurement of Al Concentration in P-type SiC Bulk Single Crystal]

In the p-type SiC bulk single crystal BU1 of the comparative example, the Al concentrations (atoms/cm$^3$) at the positions P1, P2 and P3 shown in FIG. 1 were determined by SIMS (secondary ion mass spectrometry). The positions P1, P2 and P3 were at distances of 0.1 mm, 0.8 mm and 1.5 mm, respectively, from the end surface adjacent to the SiC seed crystal SE1 in the height direction.

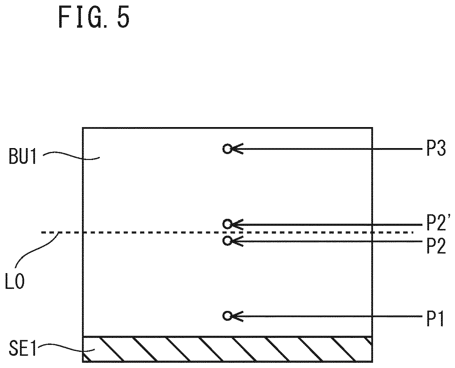

Meanwhile, in the p-type SiC bulk single crystal BU1 of the inventive example, the Al concentrations (atoms/cm$^3$) at positions P1, P2, P2' and P3 shown in FIG. 5 were determined by SIMS (secondary ion mass spectrometry). The positions P1 and P2 were at distances of 0.1 mm and 0.7 mm, respectively, from the end surface adjacent to the SiC seed crystal SE1 in the height direction. The positions P2' and P3 were located immediately above the boundary L0 between the portion of the p-type SiC single crystal grown in the first growth step and the portion of the p-type SiC single crystal grown in the second growth step, and were at distances of 0.9 mm and 1.5 mm, respectively, from the end surface adjacent to the SiC seed crystal SE1 in the height direction.

[Measurement Results]

Table 1 shows measurement results.
[Table 1]

TABLE 1

| | Al Concentration (atoms/cm$^3$) | |
| --- | --- | --- |
| | Inventive Example | Comparative Example |
| P1 | $2.8 \times 10^{20}$ | $2.8 \times 10^{20}$ |
| P2 | $2.3 \times 10^{20}$ | $2.2 \times 10^{20}$ |
| P2' | $2.7 \times 10^{20}$ | - |
| P3 | $2.3 \times 10^{20}$ | $1.4 \times 10^{20}$ |
| ΔAl | $0.5 \times 10^{20}$ | $1.4 \times 10^{20}$ |

In Table 1, "ΔAl" is the difference between the maximum value and the minimum value of the Al concentrations measured at the positions P1 to P3. As shown in Table 1, the difference ΔAl of the inventive example was smaller than the difference ΔAl of the comparative example, and the variation in Al concentration of the inventive example was small.

Embodiments of the present invention have been described. The embodiments above are, however, only examples to present how to carry out the present invention. Therefore, the present invention is not limited to the above-described embodiments, and can be carried out by appropriately modifying the above-described embodiments without departing from the spirit and scope thereof.

DESCRIPTION OF REFERENCE SYMBOLS

3:      high-frequency heating coil
6:      crucible
8:      Si-C solution
9:      SiC seed crystal
41:     seed shaft
200:    concentration recovery device

**Claims**

1.  A method for producing a p-type SiC single crystal by a solution growth technique by use of a production apparatus comprising a crucible and a seed shaft, wherein, the seed shaft including a bottom edge to which a SiC seed crystal is attachable and being movable up and down, the method comprising:

    a formation step of forming a Si-C solution in the crucible, wherein the Si-C solution containing Si, Al and C;
    a first growth step of moving down the seed shaft to bring the SiC seed crystal attached to the bottom edge of the seed shaft onto contact with the Si-C solution and thereafter growing an Al-doped p-type SiC single crystal on the SiC seed crystal;
    a recovery step of increasing an Al concentration in the Si-C solution after the first growth step; and
    a second growth step of further growing the p-type SiC single crystal after the recovery step.

2.  The method for producing a p-type SiC single crystal according to claim 1, wherein
    the recovery step includes:

    a separation step of moving up the seed shaft to separate the p-type SiC single crystal grown on the SiC seed crystal from the Si-C solution;
    a concentration adjustment step of increasing the Al concentration in the Si-C solution after the separation step; and
    after the concentration adjustment step, a contact step of moving down the seed shaft to bring the p-type SiC seed crystal onto contact with the Si-C solution.

3.  The method for producing a p-type SiC single crystal according to claim 2, wherein
    the recovery step further includes a temperature adjustment step of adjusting a temperature of the Si-C solution to a crystal growth temperature after the concentration adjustment step and before the contact step.

4.  The method for producing a p-type SiC single crystal according to claim 2 or 3, wherein
    in the concentration adjustment step, an Al-Si-based alloy is supplied to the Si-C solution.

5.  The method for producing a p-type SiC single crystal according to any one of claims 1 to 4, wherein:

    the Si-C solution formed in the formation step further contains Cu; and
    in the recovery step, a Cu concentration as well as the Al concentration in the Si-C solution is increased.

FIG. 1

BU1

SE1

P3

P2

P1

FIG. 2

FIG. 3

EP 3 192 899 A1

FIG. 4

```
                 ┌──────────────┐
                 │    Start     │
                 └──────┬───────┘
                        │
                        ▼
                 ┌──────────────┐
                 │ formation step │  S1
                 └──────┬───────┘
                        │
                        ▼
                 ┌──────────────┐
                 │ first growth step │  S2
                 └──────┬───────┘
                        │                recovery step  S3
          ┌ ─ ─ ─ ─ ─ ─┼─ ─ ─ ─ ─ ─ ─ ─ ─ ┐
          │            ▼                     │
          │     ┌──────────────┐            │
          │     │ separation step │  S31     │
          │     └──────┬───────┘            │
          │            │                     │
          │            ▼                     │
          │     ┌──────────────┐            │
          │     │ concentration  │  S32      │
          │     │ adjustment step│            │
          │     └──────┬───────┘            │
          │     ┌──────┤                     │
          │     │      ▼                     │
          │     │┌──────────────┐           │
          │     ││ temperature   │  S34      │
          │     ││ adjustment step│          │
          │     │└──────┬───────┘           │
          │     └──────►│                    │
          │            ▼                     │
          │     ┌──────────────┐            │
          │     │ contact step  │  S33       │
          │     └──────┬───────┘            │
          └ ─ ─ ─ ─ ─ ─┼─ ─ ─ ─ ─ ─ ─ ─ ─ ┘
                        ▼
                 ┌──────────────┐
                 │ second growth step │  S4
                 └──────┬───────┘
                        │
                        ▼
                 ┌──────────────┐
                 │    Finish    │
                 └──────────────┘
```

15

FIG. 5

## INTERNATIONAL SEARCH REPORT

| International application No. |
| --- |
| PCT/JP2015/004411 |

**A. CLASSIFICATION OF SUBJECT MATTER**
*C30B29/36(2006.01)i, C30B19/04(2006.01)i*

According to International Patent Classification (IPC) or to both national classification and IPC

**B. FIELDS SEARCHED**

Minimum documentation searched (classification system followed by classification symbols)
C30B1/00-35/00, H01L21/208

Documentation searched other than minimum documentation to the extent that such documents are included in the fields searched
| | | | |
| --- | --- | --- | --- |
| Jitsuyo Shinan Koho | 1922–1996 | Jitsuyo Shinan Toroku Koho | 1996–2015 |
| Kokai Jitsuyo Shinan Koho | 1971–2015 | Toroku Jitsuyo Shinan Koho | 1994–2015 |

Electronic data base consulted during the international search (name of data base and, where practicable, search terms used)
JSTPlus/JST7580(JDreamIII)

**C. DOCUMENTS CONSIDERED TO BE RELEVANT**

| Category* | Citation of document, with indication, where appropriate, of the relevant passages | Relevant to claim No. |
| --- | --- | --- |
| A | JP 2009-179491 A (Toyota Motor Corp.), 13 August 2009 (13.08.2009), claims 1, 3; paragraphs [0021] to [0026]; fig. 1 & US 2010/0308344 A1 claims 1, 8; paragraphs [0024] to [0028]; fig. 1 & DE 112009000196 B    & KR 10-2010-0100977 A & CN 101932757 A | 1–5 |
| A | Takayuki SHIRAI,et al., Solution growth of p-type 4H-SiC bulk crystals with low resistivity, Materials Science Forum, 2014.02, Volumes 778-780, p.75-78, ISSN 1662-9752, particularly, Abstract, Fig.6 | 1–5 |

☒ Further documents are listed in the continuation of Box C.        ☐ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered    to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 28 October 2015 (28.10.15) | 10 November 2015 (10.11.15) |

| Name and mailing address of the ISA/ | Authorized officer |
| --- | --- |
| Japan Patent Office 3-4-3,Kasumigaseki,Chiyoda-ku, Tokyo 100-8915,Japan | Telephone No. |

Form PCT/ISA/210 (second sheet) (July 2009)

**INTERNATIONAL SEARCH REPORT**

| International application No. |
|---|
| PCT/JP2015/004411 |

C (Continuation).    DOCUMENTS CONSIDERED TO BE RELEVANT

| Category* | Citation of document, with indication, where appropriate, of the relevant passages | Relevant to claim No. |
|---|---|---|
| A | JP 2008-100890 A (Sumitomo Metal Industries, Ltd.), 01 May 2008 (01.05.2008), claim 1; paragraphs [0061] to [0071]; fig. 1 to 3 (Family: none) | 1-5 |
| A | JP 2013-540094 A (SK Innovation Co., Ltd.), 31 October 2013 (31.10.2013), claims 1, 2; paragraphs [0027] to [0031]; fig. 2, 3 & WO 2012/053782 A2 claims 1, 2; [45] to [49]; fig. 2, 3 & US 2013/0305982 A1    & EP 2630278 A2 & KR 10-2012-0041549 A   & CN 103180493 A | 1-5 |
| A | JP 2011-98853 A (Toyota Motor Corp.), 19 May 2011 (19.05.2011), claim 1; paragraphs [0001], [0012] to [0016] (Family: none) | 1-5 |
| P,A | JP 2014-189420 A (Kyocera Corp.), 06 October 2014 (06.10.2014), claims 6, 9; paragraphs [0031], [0037] to [0045], [0056] to [0057]; fig. 1 (Family: none) | 1-5 |
| P,A | JP 2015-67489 A (Kyocera Corp.), 13 April 2015 (13.04.2015), claims 1, 5; paragraphs [0037] to [0045], [0063] to [0064]; fig. 1 (Family: none) | 1-5 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **TAKAYUKI SHIRAI et al.** Solution Growth of P-type 4H-SiC Bulk Crystals with Low Resistivity. *Materials Science Forum,* 2014, vol. 778-780, 75-78